# EUROPEAN PATENT SPECIFICATION

(11) **EP 1 946 229 B1**
(45) Date of publication and mention of the grant of the patent: **16.05.2012**
(21) Application number: 06780492.2
(22) Date of filing: 13.09.2006
(51) Int. Cl.: G06F 17/50, H01L 27/118, G06K 9/60

(54) **A CONFIGURABLE ASIC-BASED SENSING CIRCUIT**
KONFIGURIERBARE MESSSCHALTUNG AUF ASIC-BASIS
CIRCUIT DE DETECTION ASIC CONFIGURABLE

(30) Priority: 13.09.2005 US 716173 P
(43) Date of publication of application: 23.07.2008
(73) Proprietor: Ben-Gurion University Of The Negev Research And Development Authority, 84105 Beer Sheva (IL)
(72) Inventor: ARTYOMOV, Evgeny, 76242 Rechovot (IL); FISH, Alexander, 38495 Hadera (IL); YADID-PECHT, Orly, 34995 Haifa (IL); MALIATSKI, Boris, 49404 Petach-Tikva (IL)
(74) Representative: Machtalère, Georges
(86) International application number: PCT/IL2006/001075
(87) International publication number: WO 2007/032006

(56) References cited:
- US-A1- 2005 017 315
- US-B1- 6 778 212
- ZAHIRI B ED - INSTITUTE OF ELECTRICAL AND ELECTRONICS ENGINEERS: "Structured ASICs:opportunities and challenges" PROCEEDINGS 2003 IEEE INTERNATIONAL CONFERENCE ON COMPUTER DESIGN: VLSI IN COMUTERS AND PROCESSORS. ICCD 2003. SAN JOSE, CA, OCT. 13 - 15, 2003, INTERNATIONAL CONFERENCE ON COMPUTER DESIGN, LOS ALAMITOS, CA, IEEE COMP. SOC, US, 13 October 2003 (2003-10-13), pages 404-409, XP010664121 ISBN: 0-7695-2025-1
- VINCENT J A ET AL: "A customizable timing controller for electronic imaging applications" PROCEEDINGS OF THE CUSTOM INTEGRATED CIRCUITS CONFERENCE. SAN DIEGO, MAY 12 - 15, 1991, NEW YORK, IEEE, US, vol. CONF. 13, 12 May 1991 (1991-05-12), pages 12.7.1-12.7.5, XP010044527 ISBN: 0-7803-0015-7

## Description

### FIELD AND BACKGROUND OF THE INVENTION

The present invention relates to configurable sensors with processing capabilities, and, more particularly, but not exclusively to configurable image sensors with image processing capabilities.

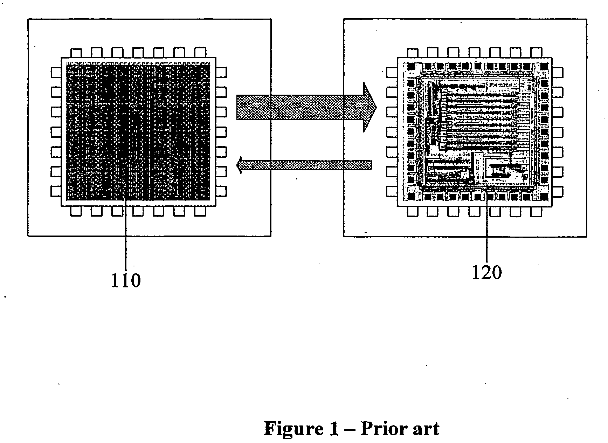

Image processing is a broad field, with applications in fields such as digital photography, medical imaging, and microscopy. Fig. 1 illustrates a typical image-processing system architecture. The image-processing pipeline is based on the assumption that at least two separate system components exist, a sensor 110 that captures image data and a processor 120 that processes the sensor data and performs sensor control.

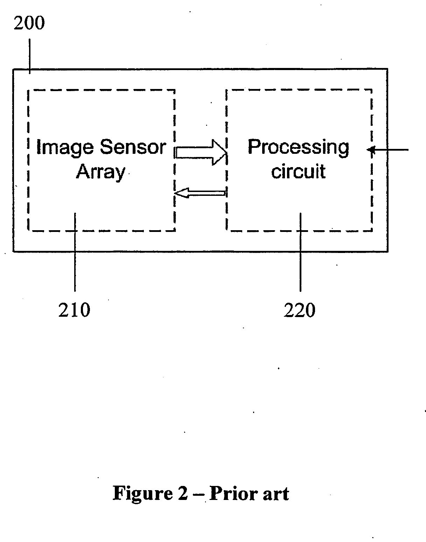

Current state-of-the-art technology, such as CMOS, allows the integration of an image sensor with processing components on the same die, as shown in Fig. 2. Thus a single integrated circuit (IC) 200 may contain both an image sensor array 210, for gathering image data, and a processing circuit 220, for performing image-processing algorithms. These algorithms include functions such as: data compression, color processing, image enhancement, uniformity correction, edge/motion detection, digital watermarking, object tracking, window(s) definition, and pattern recognition. Such integration can lead to miniaturization, lower production costs and reduced power dissipation.

The image processing component (or components) of a typical single-chip image sensor may include field-programmable gate arrays (FPGA), digital signal processors (DSP), processors, and incorporate processing software. Multiple components lead to high system cost, high power dissipation and a large form-factor that may be unsuitable for low-cost applications (such as toys and optical mice), low power applications (such as space and mobile), and applications that require miniaturization (such as medical).

An additional disadvantage is that the development of such integrated sensors generally requires high NRE investments and long time-to-market. In the case of high volume production this large investment of resources can be justified. However, for low volume production the NRE leads to high sensor cost.

US Pat. No. 6,617,565 by Wu presents an example of an IC containing both an image sensor and a processing circuit, and capable of performing pattern recognition. The sensor array outputs raw image data, and the processing circuit receives the raw image data and outputs a feature set based upon the raw image data. However, in Wu the processing circuitry may be implemented as a field programmable gate array (FPGA), which is slow and has high power consumption, or as a neural network, which requires intensive user customization and consequently high non-recurring engineering (NRE) costs.

Another example of an integrated IC image sensor and processor is found in US Pat. No. 6,778,212 by Deng et al. Deng presents a digital sensor array and programmable logic device (PLD) that are formed on a substrate using CMOS processing techniques. Examples of such programmable logic devices include Simple Programmable Logic Devices (SPLD), Complex Programmable Logic Devices (CPLD), FPGAs, or Field Programmable Interconnect Devices (FPID). All these logic devices are field-programmable, and consequently do not achieve the space, power and other benefits of an application-specific integrated circuit (ASIC) customized for a particular use.

U.S. Pat. No. 6,549,235 by Fossum et al. presents a single substrate device formed to have an image acquisition device and a controller. The controller on the substrate controls the system operation. Fossum et al. present specialized support electronics that are integrated onto the same substrate as the photosensitive element, so as to include integration, timing, control electronics, signal chain electronics, A/D conversion, and other control systems integrated on the same substrate as the photosensitive element.

U.S. Pat. Appl. No. 20040080649 by Chang teaches a CMOS image sensor single chip integrated with a micro processing unit utilizing CMOS technology. The CMOS image sensor receives the input light from outside, and transforms the input light to a sensing voltage, which is then transferred to the image signal through the circuit with the sensor. The micro processing unit receives and transforms the image signal according to the firmware programs for further control and application. Neither Fossum et al. nor Chang present a design methodology for specifying the image sensor device for fabrication.

A design approach known as structured (or platform) ASIC was introduced in US Pat. No. 6,819,136 by Or-Bach. Structured ASIC design relaxes the ASIC design problem by using pre-designed primitive gates or/and macro-blocks. The circuit functionality is configured using only a subset of the metal layers or vias, rather than all layers as required for full custom or cell based ASICs. Such an approach significantly reduces the NRE cost and shortens the time-to-market. Structured ASICs are sometime used to implement designs that are prototyped in FPGAs. Structured ASIC typically saves area and power relative to the FPGA design.

US Pat. 6,778,212 by Deng teaches an image sensor, including a substrate having formed thereon by a CMOS process a digital sensor array having a plurality of digital pixel sensors which output analog signals corresponding to a desired image. The digital sensor array further includes supporting circuitry for converting the analog signals produced by the digital pixel sensors to digital signals corresponding to the desired image. Filter circuitry, for converting the digital signals to digital values representative of the light intensity impinging upon the plurality of digital pixel sensors, is also formed on the substrate using CMOS fabrication processes. Memory devices, including a data memory, a threshold memory, and a time index memory are formed on the substrate using CMOS fabrication techniques. A clock circuit is also formed on the substrate using CMOS fabrication processes. Programmable logic structures are formed on the substrate using CMOS fabrication processes. The programmable logic structure can be configured into a variety of circuitry or routing so as to facilitate customization or specialization of the image sensor. "Structured ASICs: Opportunities and Challenges" by Zahiri (published in Proc. of IEE Intl. Conf. on Computer Design, 2003) presents structured ASIC integrated circuits. Tiles containing a small amount of generic logic implemented either as gates and/or multiplexers and/or a lookup table are designed. An array of these tiles is then prefabricated across the face of the chip.

"A Customizable Timing Controller for Electronic Imaging Applications" by Vincent (published in Proc. of IEE Custom Integrated Circuits Conference, 1991) presents a programmable video timing and control ASIC that was designed in a full-custom manner using a silicon compiler tool set. The device architecture is specifically tailored to addressing the system requirements of video and other electronic imaging systems, incorporating genlock and defect correction functions. Customization requires only a VIA mask change, allowing the base architecture to be fabricated in advance, like a gate array.

There is thus a widely recognized need for, and it would be highly advantageous to have, an ASIC integrated sensor and processor devoid of the above limitations.

### SUMMARY OF THE INVENTION

According to a first aspect of the present invention there is provided a sensing circuit based on an application-specific integrated circuit (ASIC) sensor which includes a sensor portion and a processor portion which are integrated on an ASIC. The sensor portion outputs raw output in response to a stimulus. The output of the sensor portion is processed by the processor portion. The sensor portion and the processor portion together form at least two blocks which are configurable together by interconnections in two or more ways to produce differentiated sensing products.

According to a second aspect of the present invention there is provided a method of designing a sensing circuit based on an ASIC. The method includes the steps of: designing a sensor portion for outputting a signal in response to a stimulus; designing a processor portion for processing the output signal; defining a common interconnection for a sensing circuit comprising the sensor portion and the processor portion, the common interconnection defining a minimalist structure of the sensing circuit; and defining a custom interconnection for at least one of the sensor portion and the processor portion in accordance with a custom specification.

According to a third aspect of the present invention there is provided a method of manufacturing a sensing circuit based on an ASIC. The method includes the steps of: designing a bottom subset of ASIC masks in accordance with a common interconnection, wherein the common interconnection is defined for a sensing circuit comprising a sensor portion for outputting a signal in response to a stimulus and a processor portion for processing the output signal; fabricating a fixed portion of the sensing circuit in accordance with the bottom subset; designing a top subset of ASIC masks in accordance with a custom interconnection, wherein the custom interconnection is defined for at least one of the sensor portion and the processor portion in accordance with a custom specification; and completing fabrication of the ASIC sensor in accordance with the top subset.

According to a fourth aspect of the present invention there is provided a method of manufacturing a sensing circuit based on an ASIC. The method includes the steps of: providing a design of a minimalist structure of the sensing circuit in accordance with a common interconnection, wherein the common interconnection is defined for a sensing circuit comprising a sensor portion for outputting a signal in response to a stimulus and a processor portion for processing the output signal; fabricating a fixed portion of the sensing structure in accordance with the minimalist structure design; providing a design of a customized structure in accordance with a custom interconnection, wherein the custom interconnection is defined for at least one of the sensor portion and the processor portion in accordance with a custom specification; and completing fabrication of the sensing circuit in accordance with the customized structure design.

According to a fifth aspect of the present invention there is provided a method of designing an ASIC image sensor. The method includes the steps of: specifying an array of photosensitive sensing elements; defining an interconnection between the sensing elements and at least one sensor output in order to provide a customized pixel configuration; and designing a subset of ASIC masks in accordance with the defined interconnection.

The present invention successfully addresses the shortcomings of the presently known configurations by providing a configurable ASIC sensor which includes an integrated sensor and processor, and which may be customized to a user's needs.

Unless otherwise defined, all technical and scientific terms used herein have the same meaning as commonly understood by one of ordinary skill in the art to which this invention belongs. Although methods and materials similar or equivalent to those described herein can be used in the practice or testing of the present invention, suitable methods and materials are described below. In case of conflict, the patent specification, including definitions, will control. In addition, the materials, methods, and examples are illustrative only and not intended to be limiting.

Implementation of the method and system of the present invention involves performing or completing selected tasks or steps manually, automatically, or a combination thereof. Moreover, according to actual instrumentation and equipment of preferred embodiments of the method and system of the present invention, several selected steps could be implemented by hardware or by software on any operating system of any firmware or a combination thereof. For example, as hardware, selected steps of the invention could be implemented as a chip or a circuit. As software, selected steps of the invention could be implemented as a plurality of software instructions being executed by a computer using any suitable operating system. In any case, selected steps of the method and system of the invention could be described as being performed by a data processor, such as a computing platform for executing a plurality of instructions.

### BRIEF DESCRIPTION OF THE DRAWINGS

The invention is herein described, by way of example only, with reference to the accompanying drawings. With specific reference now to the drawings in detail, it is stressed that the particulars shown are by way of example and for purposes of illustrative discussion of the preferred embodiments of the present invention only, and are presented in the cause of providing what is believed to be the most useful and readily understood description of the principles and conceptual aspects of the invention. In this regard, no attempt is made to show structural details of the invention in more detail than is necessary for a fundamental understanding of the invention, the description taken with the drawings making apparent to those skilled in the art how the several forms of the invention may be embodied in practice.

In the drawings:
Fig. 1 illustrates a typical image-processing system architecture.
Fig. 2 is a simplified block diagram of an image sensor integrated with a processing circuit.
Fig. 3 is a simplified block diagram of a configurable ASIC sensor (CAS), according to a preferred embodiment of the present invention.
Fig. 4 is a simplified block diagram of a CAS sensor, according to a preferred embodiment of the present invention.
Fig. 5a is a simplified block diagram of a CAS configuration employing row parallel readout and parallel image processing, according to a preferred embodiment of the present invention.
Fig. 5b is a simplified block diagram of a CAS configuration employing row parallel readout and pipeline image processing, according to a preferred embodiment of the present invention.
Fig. 6a shows a first exemplary layout of a sensor array formed of photosensitive sensing elements.
Figs. 6b and 6c show alternate configurations of the sensor array.
Fig. 7a illustrates a second exemplary layout of sensor array formed of photosensitive sensing elements.
Fig. 7b shows an exemplary sensor array configuration, containing three areas having different resolutions.
Fig. 8a illustrates a non-limiting example of a transistor scheme for a configurable 3-transistor pixel.
Figs. 8b-8d illustrate a non-limiting example of a mask implementation for a configurable 3-transistor pixel.
Fig. 9 is a simplified block diagram of a predefined CAS fixed structure, according to a preferred embodiment of the present invention.
Fig. 10 is a simplified block diagram of a CAS configured for spatial convolution computation, according to a preferred embodiment of the present invention.
Fig. 11 is a simplified block diagram of a CAS configured for histogram calculation, according to a preferred embodiment of the present invention.
Fig. 12 is a simplified flowchart of a CAS design/fabrication process, according to a preferred embodiment of the present invention.
Fig. 13 is a simplified flowchart of a method of designing a CAS, according to a preferred embodiment of the present invention.
Figs. 14a and 14b are simplified flowcharts of methods of manufacturing a CAS, according to a first and second preferred embodiment of the present invention.
Fig. 15 is a simplified flowchart of a method of designing an ASIC image sensor, according to a preferred embodiment of the present invention.

### DESCRIPTION OF THE PREFERRED EMBODIMENTS

The present embodiments teach a configurable sensor and associated processor formed as a single ASIC. Specifically, the present embodiments teach a sensor integrated with processing circuitry, which may be configured utilizing a structured ASIC design methodology.

In the following the term configurable indicates that the interconnections within a block or between the block and other circuit blocks may be connected in more than one functional configuration. The term fixed indicates that the connections within an element or between the element and other circuit elements are predefined.

The present embodiments describe a sensing circuit (denoted herein a Configurable ASIC Image Sensor or CAS), which may be interconnected in different ways to form different types of ASIC sensors, having differing capabilities and functionality. A CAS consists of an ASIC which includes a sensor (or sensors) and processing circuitry, one or both of which are configurable. The circuit functionality may be configured using a subset of the ASIC metal layers, vias, or other available layers. In the preferred embodiment, the processing circuitry is designed as a predefined set of processing blocks similarly to the structured ASIC approach.

The present embodiments eliminate high NRE and long time-to-market problems by beginning with an initial fixed configuration of a sensor and processor, which may later be customized to a user's needs. In this way, the CAS elements may be connected according to a custom specification at a second stage of production, thereby reducing development and production costs as well as time-to-market.

The principles and operation of a configurable ASIC sensor according to the present invention may be better understood with reference to the drawings and accompanying descriptions.

Before explaining at least one embodiment of the invention in detail, it is to be understood that the invention is not limited in its application to the details of construction and the arrangement of the components set forth in the following description or illustrated in the drawings. The invention is capable of other embodiments or of being practiced or carried out in various ways. Also, it is to be understood that the phraseology and terminology employed herein is for the purpose of description and should not be regarded as limiting.

For exemplary purposes, the non-limiting embodiments described below are directed at an image sensor. However, the CAS is implementable with other types of sensors, such as pressure sensors, temperature sensors, bio-sensors, and nano-sensors, which are hereby included in the scope of the present embodiments. In addition, a combination of configurable and/or fixed sensors may be integrated within a single CAS.

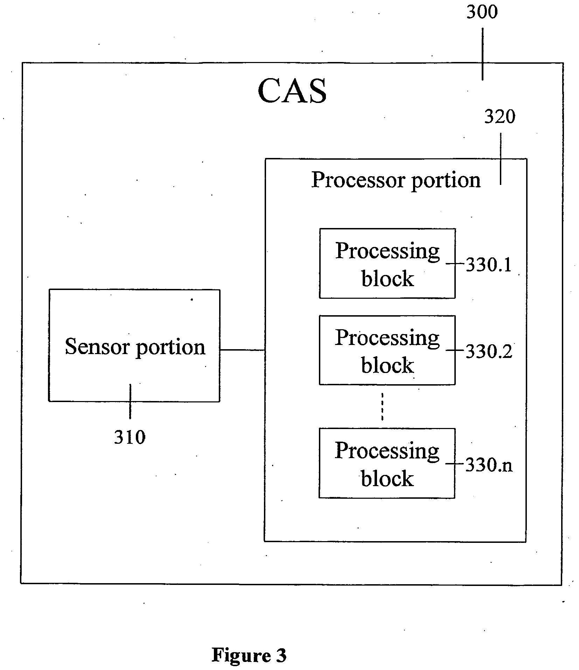

Reference is now made to Fig. 3, which is a simplified block diagram of a sensing circuit based on an ASIC (i.e. CAS), according to a preferred embodiment of the present invention. CAS 300 includes sensor portion 310 and processor portion 320. Sensor portion 310 serves to produce raw output for processing by processor portion 320. Sensor portion 310 and processor portion 320 together form at least two blocks which are configurable together by interconnections to produce differentiated sensing products. As will be discussed below, processor portion 320 may not constitute a single block, but may itself be formed of multiple processing blocks. Depending on the CAS design, the interconnections may be formed within one or more CAS blocks, and/or between the various blocks.

For clarity, in the following the term sensor denotes the sensor portion of the CAS, whereas the term CAS denotes the integrated sensor and processor.

As discussed above, producing a fully custom ASIC involves high NRE costs, which generally limit the use of ASICs to high-volume items which justify the investment. The present embodiments are based on a design concept in the CAS design begins with a fixed minimalist structure, which specifies some interconnections within and/or between the CAS elements, while leaving other connections customizable by the user. As shown in the examples below, providing an initial general-purpose fixed structure permits flexible customization of the CAS with a moderate investment of development resources.

In the preferred embodiment, the minimalist structure is defined on a subset (e.g. bottom) of the ASIC manufacturing masks, for later configuration by the customized interconnections. The customized interconnections are defined on a separate subset of the ASIC manufacturing masks, preferably the top masks. Alternately, the custom interconnections may be eBeam configurable.

CAS 300 may be fabricated by any suitable process known in the art, including but not limited to: CMOS fabrication, silicon on insulator (SOI) fabrication, silicon on sapphire (SOS) fabrication, Gallium Arsenide (GaAs) fabrication, or MEMS fabrication. For a CAS image sensor, the fabrication process should be suitable for the production of light sensitive elements.

In the preferred embodiment, the CAS processor portion is formed from a configurable set of processing blocks, thus enabling the use of a structured ASIC - design approach. As shown in Fig. 3, processor portion 320 may include one or more processing blocks 330.1-330.n, where any one of the blocks may have a fixed structure or a configurable structure.

In the preferred embodiment processor portion 320 includes one or more of the following types of processing block:
1) Analog to digital converter (ADC) block
2) Logic block
3) Analog processing block
4) Digital processing block
5) Memory block
6) Input/output (I/O) block
7) Micro-electrical-mechanical system (MEMS) block
Each of the above types is now described in turn.

An A/D converter is used to generate a digital representation of analog signals generated by the sensor. The ADC block may contain several A/D converters, each connected to a respective sensor output. For example, when the sensor consists of an array of photosensitive elements, the ADC block may be implemented per pixel, per column, per several columns, or as a single ADC block for the whole array. The ADC block may have an n-bit digital output, and may be implemented using dual slope, single slope, successive approximation, sigma delta, pipeline, or by other approaches known in the art. The ADC block may be fixed or configurable (fully or in part). In the configurable case, ADC resolution, power consumption and specification may be configurable according to the requirements of the specific application.

A logic block implements logical operations, such as signal processing control or performing arithmetic operations. For example, a logic block may serve as a CAS controller which controls the overall operation of the CAS. In another example, logic block serves as a sensor controller which controls the data readout, sensor resolution, defines windows of interest, and so forth. Other possible types of logic block include: an arithmetic unit, a column parallel image processor, a serial image processor, a sensor array dynamic range adjuster, and a sensor array resolution adjuster.

An analog processing block includes analog circuit elements for performing processing at the analog level. The analog processing block may be implemented as fixed or configurable (fully or in part).

A digital processing block performs processing at the digital level. The digital processing circuitry may include simple and complex logic gates, such as OR, AND, NAND, NOR, XOR, A and (not B), A or (not B), multiplexer (MUX), Flip-flops, look-up tables (LUT), adders, multipliers, subtractors, dividers, and others. In addition, a digital processing block may include memory cells for more efficient processing. The processing may be performed in parallel, serial, data-flow, pipeline, their combination and in other ways. The digital circuitry may be also used to decrease/increase the resolution of the sensors array when this is required.

The digital circuitry may be fixed, fully or partially configurable. In a configurable digital processing block, all or part of the elements composing the digital processing block may be flexibly connected each with the other by metals or vias. The digital processing circuitry may include separate transistors for further connections by metals or vias and/or it may include simple and/complex logic gates for further connections by metal layers and/or vias, and/or simple/complex FF for further connections by metals or vias, and/or simple/complex functions for further connections by metals or vias and/or memory cells or arrays for further connections by metals or vias.

A memory block serves for saving temporary data obtained from the processing or/and data from the image sensor (the entire array or part of the array) and/or other required data. A memory block may be designed as a stand-alone processing block on the CAS and/or integrated into other CAS blocks or elements. Any type of memory known in the art and suitable for inclusion on the ASIC may be used.

The I/O block inputs and outputs data and/or other signals to and from the CAS, in order to interface with off-the-sensor circuitry. Any type of I/O port known in the art and suitable for inclusion on the ASIC may be used. Each of the I/O blocks may have its own inputs and outputs. The I/O block may operate on a digital, analog or mixed signal, and may be used to input/output analog or digital data. In an exemplary embodiment, the sensor may be integrated with a USB standard interface for digital control and for video signal output. In addition to the USB protocol, other digital or analog, standard or non-standard protocols or circuits may be used alone or together to implement the I/Os. The I/O may be fixed or configurable (fully or in part) during the fabrication stages.

An MEMS block may be produced at various stages of circuit production, prior to circuit production, during circuit production or after. Any type of MEMS known in the art and suitable for inclusion on the ASIC may be used. The MEMS elements may be designed as independent stand-alone blocks on the CAS and/or integrated into other CAS parts. An MEMS may be designed using a structured design approach by dividing the MEMS structure into basic blocks from which more complex MEMS structures may be configured.

Additionally, the minimalist structure of a CAS may include a "complicated configurable block" containing number of circuit elements which are not initially assigned to a block performing a specific function. The circuit elements in the complicated configurable block are configured into a functional processing block by the customized interconnection (rather than the common interconnection). With a complicated configurable block the design is more flexible, and the boundary between the processing blocks may be defined only during the customization stage of the CAS design. Consider a CAS in which a control logic block and an image processing block may be formed from the same types of gates and flip-flops, or even the same type of macro-block (where a macro-block may include basic primitive gates, memory arithmetic-logical blocks or more complicated structures according to the specific system requirements). When a complex controller is required, more basic elements may be configured into a controller during CAS customization; whereas when a simpler controller is required, more basic elements may be available for the image processing block.

When configurable, a block may be configured by metal layer definition (from metal 1 to last metal), by via definition, by existing layer definition (poly, active, wells, etc), and/or by MEMS elements fabrication definition.

Note that there is no significance to the geometrical position of the elements for successful CAS implementation. The data may be read out from the sensors array to one (or more) of all possible readout paths. The sensor and each one of the above-mentioned parts may be implemented in any shape, such as rectangular, square, ellipse, circular, triangular, hexagonal and so forth.

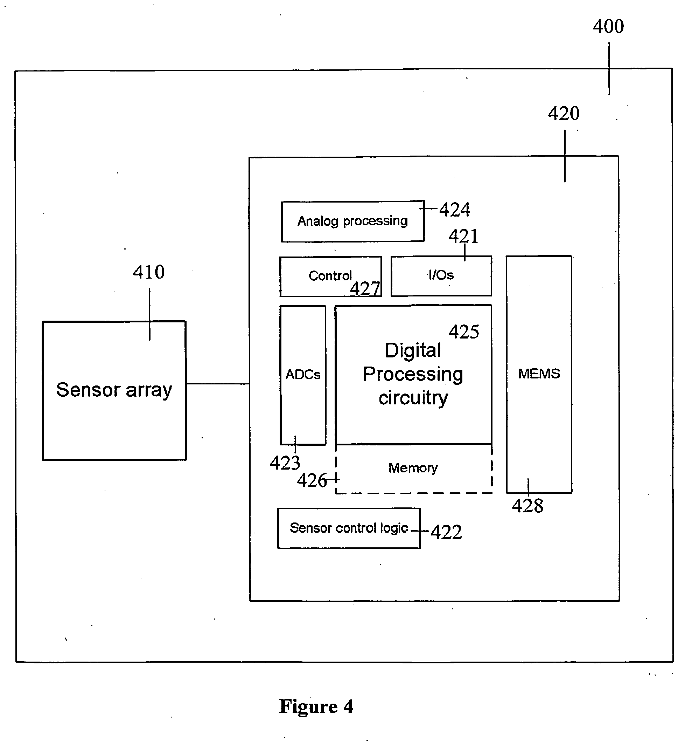

Reference is now made to Fig. 4, which is a simplified block diagram of a CAS sensor, according to a preferred embodiment of the present invention. CAS 400 contains sensor array 410, and a processor portion 420 formed from a configurable set of processing blocks. Processor portion 420 includes:
(a) Input/output block (I/Os) 421
(b) Sensor control logic 422 (i.e. logic block)
(c) ADC block 423
(d) Analog processing block 424
(e) Digital processing block 425
(f) Memory block 426 (may be part of a digital processing circuitry or alone)
(g) Control block 427 (i.e. logic block)
(h) Micro-Electro-Mechanical System (MEMS) block 428
Each of the blocks, shown in Fig. 4, may be configurable or fixed (i.e. pre-defined). For example, a fixed N bit ADC may be used to complete the analog-to-digital conversion, or the ADC block may be configured during the final stage of a specific system definition using predefined analog and/or digital blocks and more basic elements, like transistors, resistors and capacitors.

Preferably, the data is read from the sensor portion by row-by-row readout, block-by-block readout, area of interest by area of interest readout, or by any combination thereof. The data flows to the digital processing block for processing. Prior to and following processing by digital processing block 425, the data may pass additional CAS processing blocks, such as ADC block 423, analog processing block 424, memory block 426, and so forth, as required. The processing may be performed by serial or parallel processing, or by a combination of both.

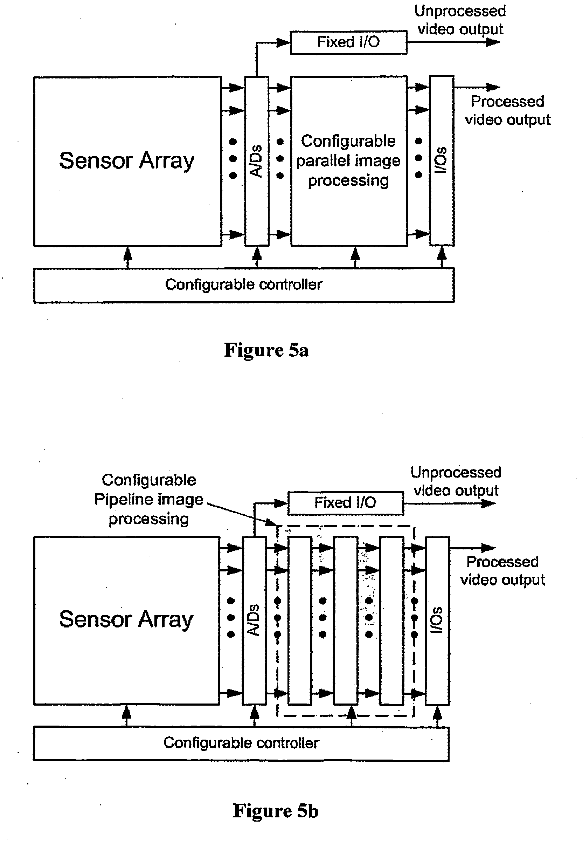

Reference is now made to Figs. 5a and 5b, which are simplified block diagrams of alternate CAS configurations, according to a first and a second preferred embodiment of the present invention. Both configurations are based on processor portion 410 of Fig. 4. Fig. 5a is a simplified block diagram of a CAS configuration employing row parallel readout and parallel image processing. Fig. 5b is a simplified block diagram of a CAS configuration employing row parallel readout and pipeline image processing.

Referring again to Fig. 3, sensor portion 310 outputs data in response to a stimulus, possibly according to parameters such as the illumination levels (for image sensors) to the CAS processor portion 320, and may receive feedback from processor portion 320 as required. In the preferred embodiment, sensor portion 310 includes one or more of: an image sensor, a pressure sensor, a temperature sensor, a bio-sensor, and a nano-sensor.

Preferably, sensor portion 310 includes an array of sensing elements (denoted herein a sensor array). The sensor array minimalist structure is generally formed with a limited number of fixed interconnections to the sensor outputs, or amongst the sensors. The remaining interconnections are then designed to a custom specification.

In a further preferred embodiment, sensor portion 310 is an image sensor formed of an array of photosensitive elements (denoted herein an image senor array). The photosensitive elements may photodiodes, photogates, metal-oxide semiconductor (MOS) capacitors, positive-intrinsic-negative (PIN) photodiodes, a pinned photodiodes, avalanche photodiodes, microbolometers, or any other type of photosensitive element known in the art.

The sensor array may be implemented using any standard or not standard sensor architecture (3T active pixel sensor (APS), 4T APS, passive pixel sensor (PPS), etc.). An image sensor array may utilize the photodiode, photogate, MOS capacitors, pin photodiode, pinned photodiode, avalanche photodiode, microbolometer and any other kind of photosensitive element or a combination of them. Any kind of photosensitive element may be integrated with any number of VLSI devices like transistors, capacitors, resistors, etc. inside or outside the pixel.

The configuration of each pixel may be fixed or configurable. In the configurable case some of the sensing elements may be configurable and others may be fixed, or all elements may be configurable. For example, the sensor array may be customized to have a uniform pixel size, or, alternately, to have a pixel size that varies over the array.

Similarly, the sensor array is preferably configurable to provide a customized pixel configuration. The customized pixel configuration preferably defines a resolution over said sensor array. The sensor array may be configured to have a uniform resolution, or, alternately, to have a resolution that varies over the array.

The resolution of the sensor may be defined in the one of the following ways:
(a) Predefined resolution - The resolution is configured in advance and may not be changed in the sensor array level during the custom fabrication. In this case the resolution may be changed using digital or/and analog processing circuitry.
(b) The maximum resolution of the array is predefined - In this case, the resolution may be reduced by sharing of a number of pixels at the array level. This may be done either logically using the feedback from the sensors control block, or by physical sharing between the pixels.
(c) Fully flexible resolution - The sensor array is fully configurable. It may be formed as a complicated configurable block integrated with other CAS blocks, and the maximum resolution (as well as the pixel size and fill factor) limited only by the specific complicated configurable block size, and the required sizes of other CAS blocks shared with the sensor.

In the preferred embodiment the sensing elements are connected so as to allow row-by-row data readout, block-by-block data readout, area of interest by area of interest readout, or any combination thereof. The sensing elements may be connected to operate in global shutter mode or in rolling shutter mode.

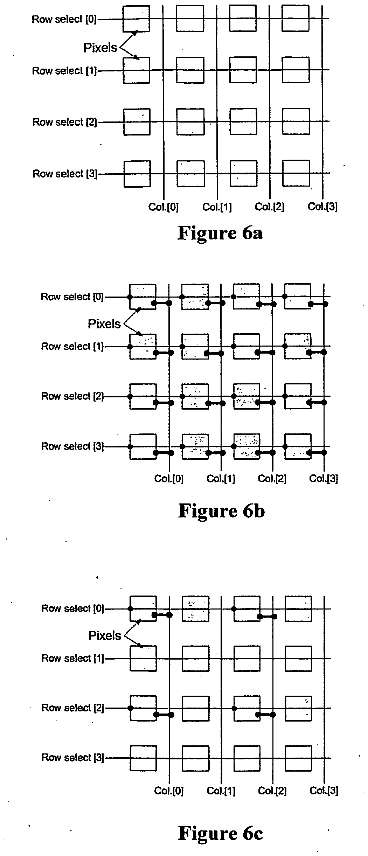

Reference is now made to Figs. 6a-6c, which illustrate the manner in which configurable image sensor array may be configured to provide a customized resolution. Fig. 6a shows an exemplary layout of sensor array formed of disconnected photosensitive sensing elements (i.e. pixels). The initial sensor array is predefined (fixed) and is common for all customers. Figs. 6b and 6c show alternate possible configurations of the sensor array of Fig. 6a, which include custom connections from the pixels to the appropriate column and row lines (using vias, metals, or any other connection), according to the user requirements. Fig. 6b shows an example where the maximum resolution is achieved. Fig. 6c shows an example where a reduced resolution is implemented.

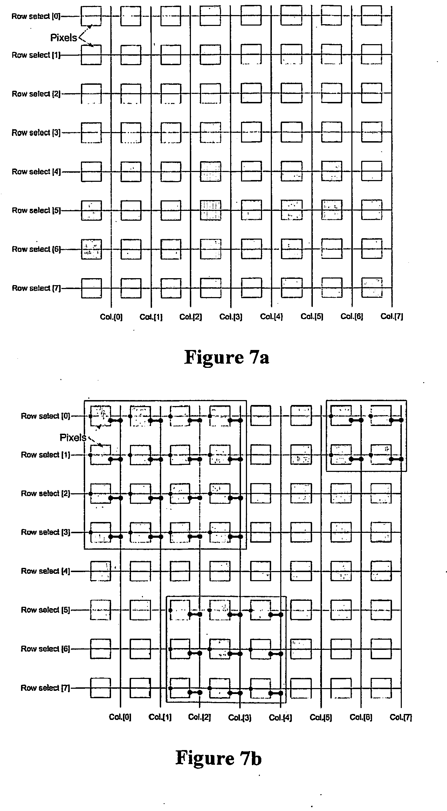

Figs. 7a-7b illustrates a further example, in which areas with varying resolutions are defined on a single image sensor array. Fig. 7a shows the initial predefined array of disconnected pixels. Fig. 7b shows the configured sensor array, which has three areas each with a different resolution (2x2, 3x3 and 4x4). The resolution for each group of pixels is defined by connecting the various pixels to the appropriate column and row lines (using vias, metals or any other way), as required by the custom specification.

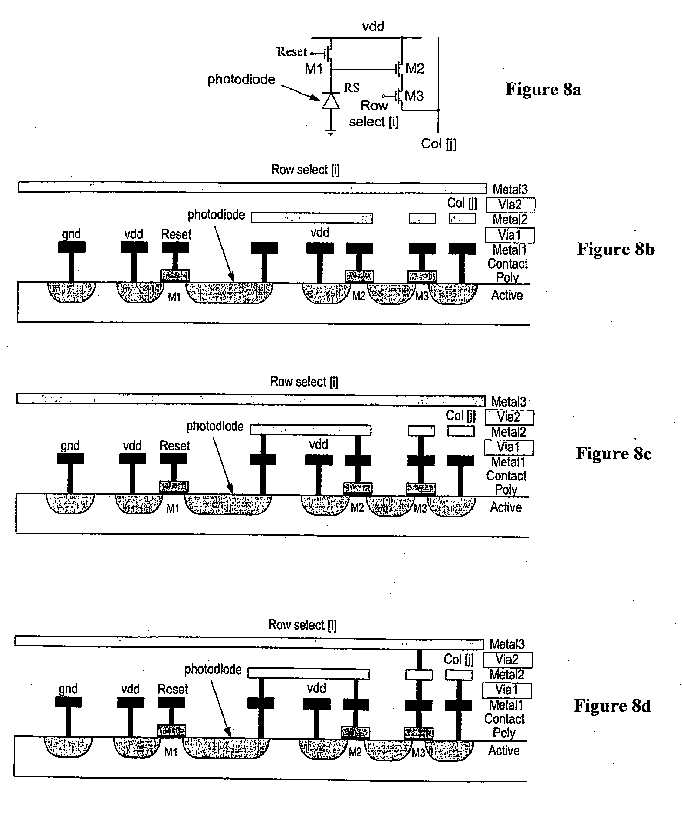

Fig. 8a is a circuit diagram of an electrical scheme for a single 3-transistor pixel. Reference is now made to Figs. 8b-8d, which illustrate a non-limiting example of a mask implementation for the 3-transistor pixel of Fig. 8a. Fig. 8b is a pixel intersection showing the predefined mask implementation for the fixed sensor array interconnections. In the present example, all masks except the Via1 and the Via2 masks are used for the fixed interconnections. Figs. 8c and 8d are pixel intersections showing the Via1 and Via2 custom mask implementations respectively, for implementing the configured sensor array interconnections. In Fig. 8c, the Via1 mask is used to complete the electrical structure of pixel(i,j), leaving it disconnected from the "Col" and "Row Select" lines (the pixel is not activated, see pixel (4,4) of Fig. 7b). In Fig. 8d the Via2 mask is used to connect pixel(i,j) to the "Col" and "Row Select" lines (the pixel is activated, see pixel (2,2) of Fig. 7b).

Image processing may be performed on data from the entire sensor array, part of the array, and on all or part of a sequence of frames. The processing may require additional internal or external data. The particular image processing algorithm used depends on the final CAS circuit configuration and circuit interaction. The CAS may implement an entire image processing algorithm or parts of the algorithm. Other parts of the algorithm may be implemented off-chip by hardware or software. The complexity of the algorithms that may be implemented depends on the basic structure of the CAS and may be increased by its redefinition.

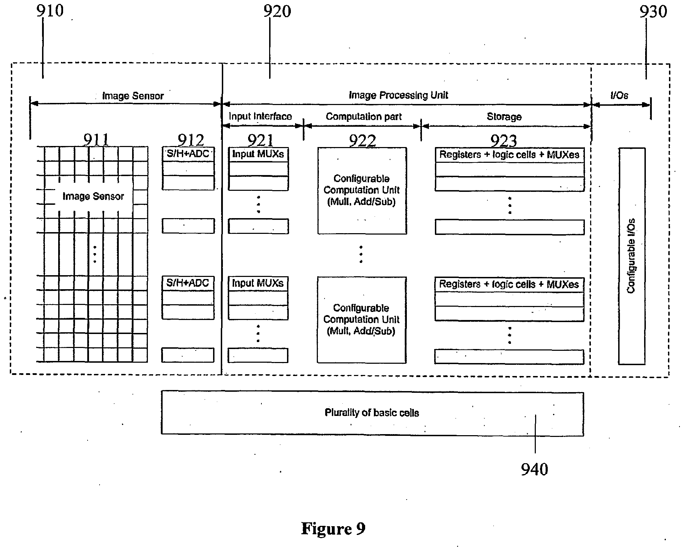

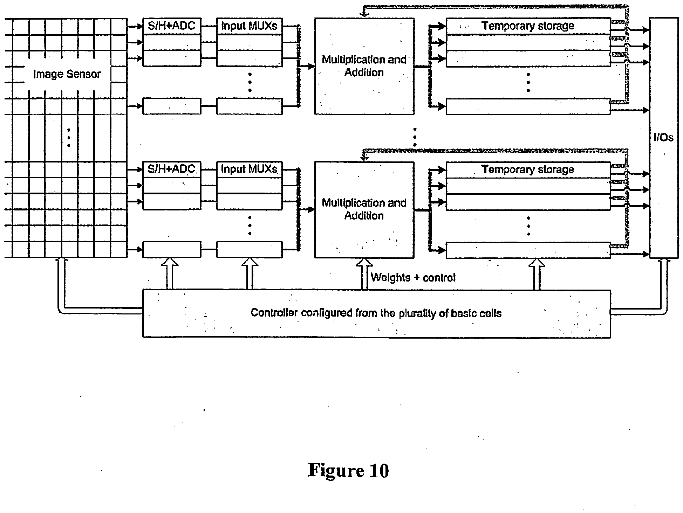

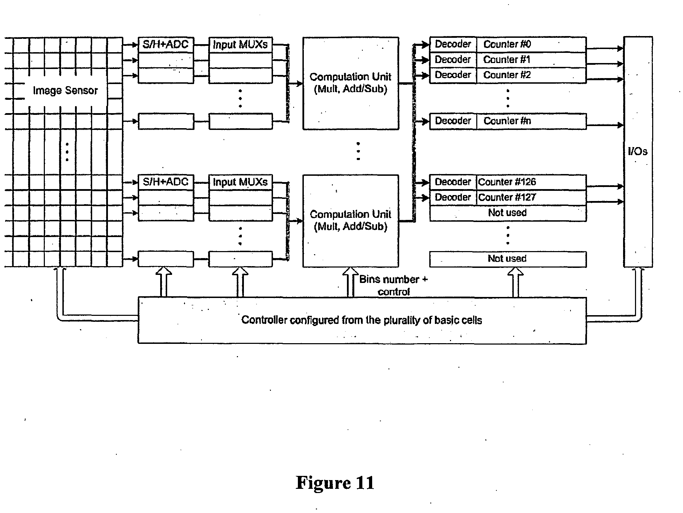

Reference is now made to Fig. 9, which is a simplified block diagram of a predefined CAS fixed structure, according to a preferred embodiment of the present invention. The basic structure shown in Fig. 9 is implemented as the fixed portion of the CAS. This fixed basic structure is suitable for column parallel architectures, and may be customized to perform different types of processing. Figs. 10 and 11 show the basic structure of Fig. 9 customized for spatial convolution and for histogram calculation respectively.

The fixed CAS structure includes an image sensor portion 910 that outputs digital data in a column parallel manner, an image processor portion 920, I/Os 930, and a plurality of basic cells 940. Image sensor portion 910 includes analog pixel elements 911 and sample and hold (S/H)+ADC 912, which provides a dedicated S/H and A/D converter for each column. Image processor portion 920 includes input interface 921, computation part 922 and storage 923. I/Os 930 are configurable input/output ports.

As shown in Figs. 10-11, image processor portion 920 may be configured (using the upper connection layers) to perform a spatial convolution with a variable kernel size or a histogram calculation with a variable number of bins. The final configuration depends on interconnection between basic cells in each block and on the interconnection between different blocks, and the controller functionality that is configured from the plurality of basic cells.

Input interface 921 includes MUXes for the commutation of the input pixel data. Each computation unit 922 includes a multiplier, an adder, a quantity of basic logic cells and MUXes. Storage 923 includes registers, MUXes and basic logic cells. Input interface 921 and storage 923 have the same repetitive structure for each column, and are placed with the same pitch as image sensor pixels. Each computation unit 922 serves a number of columns, resulting in a reduced number of such units. The total number of computation units depends on the technology used, the sensor size, frame rate and other factors.

Reference is now made to Fig. 10, which is a simplified block diagram of a CAS configured for spatial convolution computation, according to a preferred embodiment of the present invention. The spatial convolution CAS is customized from the basic structure of Fig. 9. Spatial convolution is a common and basic operation in image processing and is used for noise reduction, image enhancement, edge detection, pattern matching. In the spatial convolution configuration, each of N neighboring pixel columns (where N is the convolution kernel size) is chosen in turn by the input MUXes. The data is then transmitted to the appropriate computation unit (labeled Multiplication and Addition in Fig. 10). The computation unit multiplies the input pixel value with an appropriate convolution kernel weight, and sums the result with the previously stored data in the temporary storage. Temporary storage is required for spatial convolution, since each pixel has to be multiplied NxN times (the number of weights in the convolution kernel). The temporary storage stores intermediate data in the registers set and generates feedback to the computational unit for further accumulation. After an accumulation period that depends on the kernel size, the result of the convolution is ready for transmission. The spatial convolution CAS controller is configured from the basic cells and controls all the convolver operations.

Reference is now made to Fig. 11, which is a simplified block diagram of a CAS configured for histogram calculation, according to a preferred embodiment of the present invention. The histogram calculation CAS is also customized from the fixed structure of Fig. 9. A histogram is a function of the numbers of pixels at each brightness level in an image. Histogram calculation is another basic image processing operation, and is useful for many image processing algorithms. Fig. 11 shows an example of a CAS configured for histogram calculation with 128 bins.

In the histogram calculation CAS, the input MUXes transmit one pixel from each column of the sensor array to the computational unit. The computation unit classifies the input pixel according to its value. The classification depends on the number of bins used. In the present example, the number of bins is 128, so that it is enough to divide the result by two in order to compute its bin index. Digital division by two may be performed by a simple shift right by one bit. In addition, in the present configuration the storage part of the image processor portion is configured to implement decoders and counters. The decoder receives a bin index of the pixel from the computational unit and then activates the suitable counter. After all the sensor rows have been sampled, the resulting histogram data that is stored in counters may be transmitted out of the chip in a serial or in a parallel fashion. The CAS controller is configured from the basic cells, similarly to the spatial complex convolution CAS controller. The histogram calculation CAS controller controls all operations and resolves the signals collision issues on the computational units bus.

The above-described embodiments enable the implementation of a two-stage design and/or manufacture process. In the first stage the common interconnections defining the fixed, minimalist structure are defined, and possibly a wafer containing the fixed structure is manufactured accordingly. In the second stage the custom interconnections defining the differentiated, customized structure are defined, and the customized CAS may be manufactured.

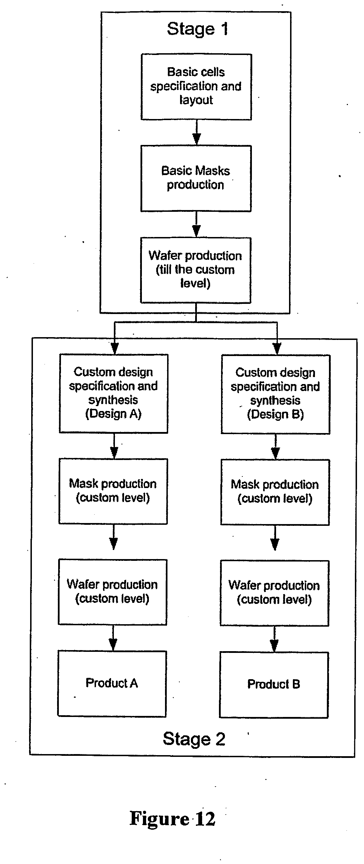

Fig. 12 is a simplified flowchart of a two-stage CAS design and fabrication process, according to a preferred embodiment of the present invention. During the first stage, the fixed minimalist CAS structure is specified, and a subset of masks is designed accordingly. A configurable wafer containing a sensor portion and a processor portion is produced using the fixed subset of masks. The fixed structure then serves as the starting point for configuration (i.e. customization) by a user. During the second stage, a customized subset of masks is designed in accordance with a user custom design. The circuit functionality may be configured using all/low/high metal layers, vias or other available layers. CAS fabrication is then completed using the customized subset of masks. Two-stage fabrication enables performing larger-scale production for the fixed structure, and limited production runs for the customized CAS.

As shown in Fig. 12, different user-specifications will generally result in different designs for the custom masks, and consequently in different CAS sensing products.

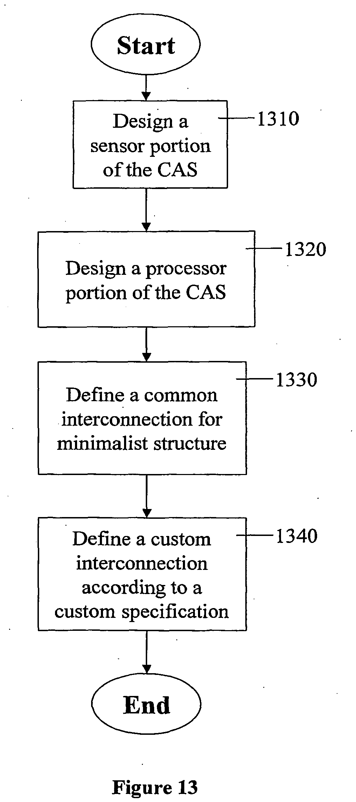

Reference is now made to Fig. 13, which is a simplified flowchart of a method of designing a configurable ASIC sensor, according to a preferred embodiment of the present invention. The present method is based on the two-stage design process, in which a common interconnection is predefined for the fixed parts of the CAS, and then a custom interconnection is defined for the configurable parts.

In step 1310 the sensor portion of the CAS is designed. The sensor design preferably describes the type or types of sensors used as well as the sensor layout. Preferably, the sensor design is based on a sensor array, as described above.

In step 1320, the processor portion is designed. The processor portion design preferably includes one or more processing blocks.

In step 1330, a common interconnection is defined. The common interconnection is specified to provide a minimalist structure, which serves as the basis for CAS customization. The common interconnection establishes which elements of the CAS are configurable, either internally or by connection to other blocks. In other words, the minimalist structure serves as a fixed, basic structure which may then be customized into a differentiated sensing circuit.

In step 1340, a custom interconnection is defined based on a custom specification. The custom interconnection specifies the connections between the processing blocks, internal to one or more processing blocks, and/or between the processor portion and the sensor portion.

Preferably the common and custom interconnections are specified on different, non-overlapping subsets of the ASIC masks. In the preferred embodiment, the common interconnection is specified on the bottom masks and the custom interconnection is specified on the top masks. An interconnection may be defined by metal layer definition, via definition, or in any other way relevant to the fabrication technology.

Alternately, the common and custom interconnections may be specified by separate (i.e. two-stage) eBeam configurations.

In the preferred embodiment the custom interconnection serves to configure the CAS for one or more of the following:
1) Parallel readout (column or row)
2) Serial readout
3) Rolling shutter mode
4) Global shutter mode
5) Pipeline processing
6) Parallel processing
7) Serial processing
8) Customized sensor resolution and/or pixel size
9) Image/Video compression
10) Color processing
11) Object recognition
12) Object tracking
Note that the above list is not intended to be limiting, and other CAS functional configurations may be achieved.

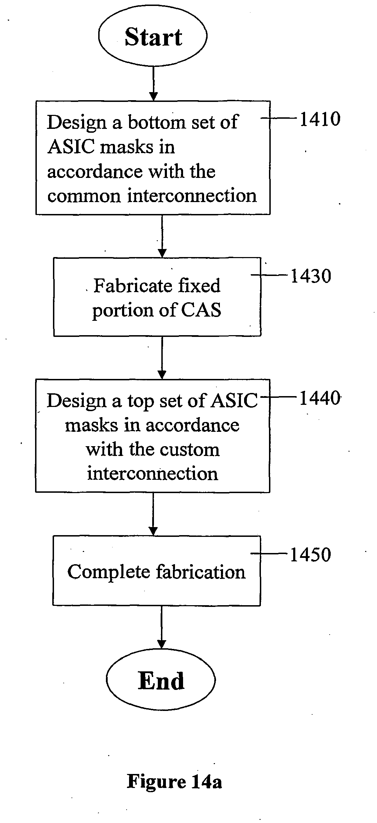

Reference is now made to Fig. 14a, which is a simplified flowchart of a method of manufacturing a configurable ASIC sensor, according to a first preferred embodiment of the present invention. In the present method, two subsets of ASIC masks are designed. The bottom masks include the common, minimalist interconnection, whereas the top masks include the custom interconnection based on a user's custom specification. The interconnections may be provided as a metal layer definition, via definition, or in any other way relevant to the fabrication technology.

In step 1410, a bottom subset of ASIC masks is designed for a CAS in accordance with a common interconnection. The CAS includes at least two blocks, a sensor portion for producing raw output data and a processor portion for processing the output data. In step 1430 the fixed portion of the CAS is fabricated from the substrate using the ASIC masks provided in step 1420. In step 1440, a top subset of ASIC masks is designed in accordance with a custom interconnection. The custom interconnection serves to configure the sensor portion and/or the processor portion of the CAS in accordance with a custom specification. In step 1450 the fabrication of the customized CAS is completed using the ASIC masks provided in step 1440. In the preferred embodiment, the sensor portion is an image sensor, preferably formed from an array of photosensitive elements.

In another preferred embodiment, steps 1430 and 1450 are performed together as a single step after the top masks are designed. A complete set of manufacturing masks may thus be made available before fabrication is begun.

The ASIC sensor may be fabricated by any suitable process known in the art, including but not limited to: CMOS fabrication, silicon on insulator (SOI) fabrication, silicon on sapphire (SOS) fabrication, Gallium Arsenide (GaAs) fabrication, or MEMS fabrication. For an ASIC image sensor, the fabrication process should be suitable for the inclusion of light sensitive elements.

As discussed above, the processor is preferably formed from a configurable set of processing blocks, such as the ones discussed above.

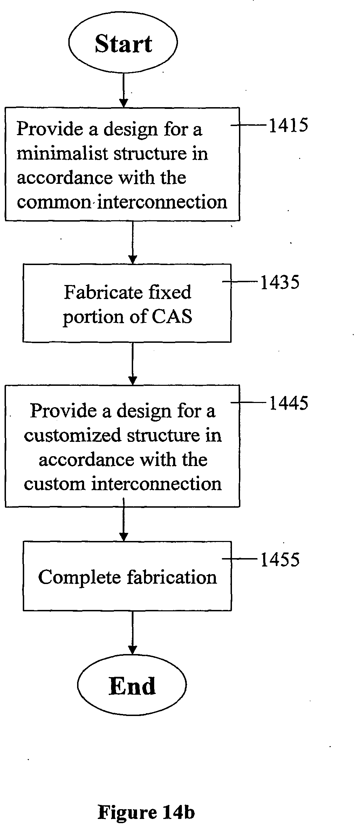

Reference is now made to Fig. 14b, which is a simplified flowchart of a method of manufacturing a configurable ASIC sensor, according to a second preferred embodiment of the present invention. The present method is suitable for both eBeam and ASIC mask configuration. In step 1415, a design for fabricating a minimalist CAS structure of the CAS is provided in accordance with a common interconnection. The CAS includes at least two blocks, a sensor portion for producing raw output data and a processor portion for processing the output data. In step 1435 a fixed portion of the CAS is fabricated from the substrate using the minimalist structure design provided in step 1425. In step 1445, a design for fabricating the customized structure of the CAS is provided in accordance with a custom interconnection. In step 1455 the fabrication of the customized CAS is completed based on the customized design provided in step 1445. In the preferred embodiment, the sensor portion is an image sensor, preferably formed from an array of photosensitive elements.

In a first preferred embodiment the common and custom designs are provided as separate subsets of the ASIC manufacturing masks. In a second preferred embodiment, the common and custom designs are separately eBeam configurable.

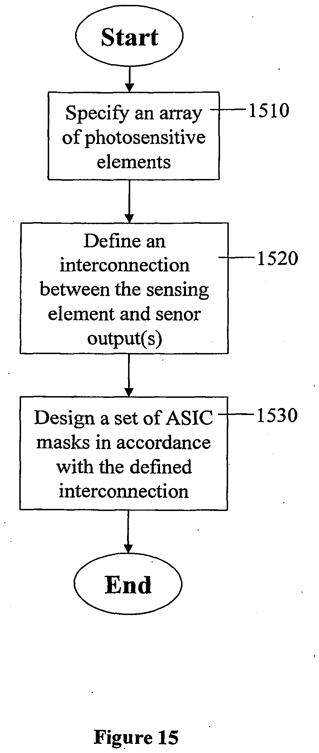

Reference is now made to Fig. 15, which is a simplified flowchart of a method of designing an ASIC image sensor, according to a preferred embodiment of the present invention. The method below is for a standalone image sensor whose pixel configuration is customized during the production stage, rather than by further circuitry or signal processing.

In step 1510, an array of photosensitive sensing elements is specified. The specification preferably includes the type of photosensitive element and the sensor layout. A photosensitive element may be a photodiode, a photogate, a metal-oxide semiconductor (MOS) capacitor, a positive-intrinsic-negative (PIN) photodiode, a pinned photodiode, an avalanche photodiode, and a microbolometer, or any other suitable sensor known in the art.

In step 1520, an interconnection between the sensing elements and at least one sensor output is specified. The interconnection is designed in order to provide a customized pixel configuration. The customized pixel configuration defines sensor array parameters such as pixel size and resolution. As indicated above, the customized resolution and/or pixel size need not be uniform for the entire sensor array. Different portions of the array may be interconnected so as to provide a different resolution and/or pixel size (see Fig. 7b).

In step 1530, a subset of ASIC masks is defined in accordance with the defmed interconnection. In the preferred embodiment, the subset defined in step 1530 is the top set of masks. In this way fixed interconnections between the sensor elements may be defined on the bottom layers, enabling the manufacturing of an initial, fixed substrate whose resolution may be configured at a later fabrication stage.

In summary, the present embodiments present a configurable ASIC sensor which includes an integrated sensor and processor, and which may be customized for a user's needs in a simple and cost-effective manner. The CAS customization process begins with a fixed structure, which is later configurable according to a custom specification. The processor may be formed from one or more processing blocks, thus enabling a structured ASIC design approach. The user is thus provided with a sensor/processor customized to his or her needs, and is spared the intensive development effort needed to produce a completely custom ASIC.

It is expected that during the life of this patent many relevant sensors, sensing elements, photosensitive elements, processing elements, and fabrication technologies will be developed and the scope of the associated terminology is intended to include all such new technologies *a priori.*

It is appreciated that certain features of the invention, which are, for clarity, described in the context of separate embodiments, may also be provided in combination in a single embodiment. Conversely, various features of the invention, which are, for brevity, described in the context of a single embodiment, may also be provided separately or in any suitable subcombination.

## Claims

1. A method of designing a structured application specific integrated circuit (ASIC) sensing circuit, comprising:
designing a sensor portion of said structured ASIC for outputting a signal in response to a stimulus;
designing a processor portion of said structured ASIC for processing said output signal;
defining a common interconnection between said sensor portion and said processor portion, said common interconnection defining a minimalist structure of said sensing circuit;
fabricating said sensor portion and said processor portion interconnected in accordance with said common interconnection; and
subsequent to said fabricating, defining a custom interconnection for at least one of said sensor portion and said processor portion in accordance with a custom specification.

2. A method according to claim 1, wherein said common interconnection and said custom interconnection are specifiable on non-overlapping subsets of a complete set of ASIC manufacturing masks.

3. A method according to any one of the preceding claims , wherein said defining a custom interconnection comprises configuring a readout mode of said sensing circuit.

4. A method according to any one of the preceding claims, wherein said defining a custom interconnection comprises configuring an interconnection of said sensor portion.

5. A method according to any one of the preceding claims, wherein said designing a processor portion comprises specifying a configurable set of processing blocks, and where defining a custom interconnection comprises at least one of: specifying connections between said processing blocks and specifying connections internal to a processing block.

6. A method according to claim 5, wherein a processing block comprises a complicated configurable block comprising circuit elements for configuration into a functional block by said custom interconnection.

7. A method according to any one of the preceding claims, wherein said defining an interconnection comprises providing a metal layer definition.

8. A method according to any one of the preceding claims, wherein said defining an interconnection comprises providing a vias definition.

9. A structured ASIC sensing circuit, the circuit comprising a sensor portion of said structured ASIC and a processor portion of said structured ASIC, the sensor portion producing raw output for processing by said processor portion, the sensor portion and the processor portion together comprising at least two blocks configurable together by interconnections in a plurality of ways to produce differentiated sensing products
**characterized by**:
wherein said sensor portion comprises an array of photosensitive elements, and wherein said sensing array is configurable to provide a customized pixel configuration.

10. A structured ASIC sensing circuit according to claim 9, wherein interconnections between said at least two blocks comprise a predefined common interconnection and a specifiable custom interconnection.

11. A structured ASIC sensing circuit according to claim 10, wherein said custom and common interconnections are specifiable on separate subsets of the ASIC manufacturing masks.

12. A structured ASIC sensing circuit according to any one of claims 9-11, wherein said interconnections are between the sensor portion and the processor portion.

13. A structured ASIC sensing circuit according to any one of claims 9-12, wherein said interconnections are within the sensor portion.

14. A structured ASIC sensing circuit according to any one of claims 9-13, wherein said interconnections are within the processor portion.

15. A structured ASIC sensing circuit according to claim 11, wherein said subset of the ASIC manufacturing masks for said custom interconnection comprises the top masks.

## Patentansprüche

1. Verfahren zum Entwerfen einer Abtastschaltung auf einer strukturierten anwendungsspezifischen integrierten Schaltung (ASIC), umfassend:
Entwerfen eines Sensorabschnitts der strukturierten ASIC zum Ausgeben eines Signals als Reaktion auf einen Reiz;
Entwerfen eines Prozessorabschnitts der strukturierten ASIC zum Verarbeiten des Ausgangssignals;
Definieren einer allgemeinen Zwischenverbindung zwischen dem Sensorabschnitt und dem Prozessorabschnitt, wobei die allgemeine Zwischenverbindung eine minimalistische Struktur der Abtastschaltung definiert;
Herstellen des Sensorabschnitts und der Prozessorabschnitts, die gemäß der allgemeinen Zwischenverbindung miteinander verbunden sind; und
Definieren nach der Herstellung einer kundenspezifischen Zwischenverbindung für mindestens einen des Sensorabschnitts und des Prozessorabschnitt gemäß einer kundenspezifischen Spezifikation.

2. Verfahren nach Anspruch 1, wobei die allgemeine Zwischenverbindung und die kundenspezifische Zwischenverbindung auf nicht überlappenden Teilsätzen eines vollständigen Satzes von ASIC-Herstellungsmasken spezifizierbar sind.

3. Verfahren nach einem der vorhergehenden Ansprüche, wobei das Definieren einer kundenspezifischen Zwischenverbindung ein Konfigurieren eines Auslesemodus der Abtastschaltung umfasst.

4. Verfahren nach einem der vorhergehenden Ansprüche, wobei das Definieren einer kundenspezifischen Zwischenverbindung ein Konfigurieren einer Zwischenverbindung des Sensorabschnitts umfasst.

5. Verfahren nach einem der vorhergehenden Ansprüche, wobei das Entwerfen eines Prozessorabschnitts ein Spezifizieren eines konfigurierbaren Satzes von Verarbeitungsblöcken umfasst, und wobei das Definieren einer kundenspezifischen Zwischenverbindung mindestens eines von Folgendem umfasst: Spezifizieren von Verbindungen zwischen den Verarbeitungsblöcken und Spezifizieren von Verbindungen innerhalb eines Verarbeitungsblocks.

6. Verfahren nach Anspruch 5, wobei ein Verarbeitungsblock einen komplizierten konfigurierbaren Block umfasst, der Schaltungselemente zur Konfiguration in einen Funktionsblock durch die kundenspezifische Zwischenverbindung umfasst.

7. Verfahren nach einem der vorhergehenden Ansprüche, wobei das Definieren einer Zwischenverbindung ein Bereitstellen einer Metallschichtdefinition umfasst.

8. Verfahren nach einem der vorhergehenden Ansprüche, wobei das Definieren einer Zwischenverbindung ein Bereitstellen einer Definition von Kontaktlöchern umfasst.

9. Strukturierte ASIC-Abtastschaltung, wobei die Schaltung einen Sensorabschnitt der strukturierten ASIC und einen Prozessorabschnitt der strukturierten ASIC umfasst, der Sensorabschnitt eine Rohausgabe zur Verarbeitung durch den Prozessorabschnitt erzeugt, und der Sensorabschnitt und der Prozessorabschnitt zusammen mindestens zwei Blöcke umfassen, die zusammen durch Zwischenverbindungen in einer Mehrzahl von Arten und Weisen konfigurierbar sind, um differenzierte Abtastprodukte zu erzeugen,
**gekennzeichnet durch**:
wobei der Sensorabschnitt eine Anordnung von lichtempfindlichen Elementen umfasst, und wobei die Abtastanordnung so konfigurierbar ist, dass sie eine kundenspezifische Pixelkonfiguration bereitstellt.

10. Strukturierte ASIC-Abtastschaltung nach Anspruch 9, wobei Zwischenverbindungen zwischen den mindestens zwei Blöcken eine vordefinierte allgemeine Zwischenverbindung und eine spezifizierbare kundenspezifische Zwischenverbindung umfassen.

11. Strukturierte ASIC-Abtastschaltung nach Anspruch 10, wobei die kundenspezifischen und allgemeinen Zwischenverbindungen auf separaten Teilsätzen der ASIC-Herstellungsmasken spezifizierbar sind.

12. Strukturierte ASIC-Abtastschaltung nach einem der Ansprüche 9 bis 11, wobei die Zwischenverbindungen zwischen dem Sensorabschnitt und dem Prozessorabschnitt sind.

13. Strukturierte ASIC-Abtastschaltung nach einem der Ansprüche 9 bis 12, wobei die Zwischenverbindungen innerhalb des Sensorabschnitts sind.

14. Strukturierte ASIC-Abtastschaltung nach einem der Ansprüche 9 bis 13, wobei die Zwischenverbindungen innerhalb des Prozessorabschnitts sind.

15. Strukturierte ASIC-Abtastschaltung nach Anspruch 11, wobei der Teilsatz der ASIC-Herstellungsmasken für die kundenspezifische Zwischenverbindung die oberen Masken umfasst.

## Revendications

1. Procédé destiné à concevoir un circuit de détection de circuit intégré à application spécifique structuré (ASIC), comprenant les étapes ci-dessous consistant à :
concevoir une partie de capteur dudit circuit ASIC structuré en vue de générer en sortie un signal en réponse à un stimulus ;
concevoir une partie de processeur dudit circuit ASIC structuré en vue de traiter ledit signal généré en sortie ;
définir une interconnexion commune entre ladite partie de capteur et ladite partie de processeur, ladite interconnexion commune définissant une structure minimaliste dudit circuit de détection ;
fabriquer ladite partie de capteur et ladite partie de processeur interconnectées selon ladite interconnexion commune ; et
subséquemment à ladite fabrication, définir une interconnexion personnalisée pour au moins l'une parmi ladite partie de capteur et ladite partie de processeur selon une spécification personnalisée.

2. Procédé selon la revendication 1, dans lequel ladite interconnexion commune et ladite interconnexion personnalisée peuvent être spécifiées sur des sous-ensembles sans chevauchement d'un ensemble complet de masques de fabrication de circuits ASIC.

3. Procédé selon l'une quelconque des revendications précédentes, dans lequel ladite étape consistant à définir une interconnexion personnalisée comprend l'étape consistant à configurer un mode de lecture dudit circuit de détection.

4. Procédé selon l'une quelconque des revendications précédentes, dans lequel ladite étape consistant à définir une interconnexion personnalisée comprend l'étape consistant à configurer une interconnexion de ladite partie de capteur.

5. Procédé selon l'une quelconque des revendications précédentes, dans lequel ladite étape consistant à concevoir une partie de processeur comprend l'étape consistant à spécifier un ensemble configurable de blocs de traitement, et dans lequel l'étape consistant à définir une interconnexion personnalisée comprend au moins l'une des étapes ci-après consistant à :
spécifier des connexions entre lesdits blocs de traitement et spécifier des connexions internes à un bloc de traitement.

6. Procédé selon la revendication 5, dans lequel un bloc de traitement comprend un bloc configurable complexe comprenant des éléments de circuit destinés à être configurés dans un bloc fonctionnel par ladite interconnexion personnalisée.

7. Procédé selon l'une quelconque des revendications précédentes, dans lequel ladite étape consistant à définir une interconnexion comprend l'étape consistant à délivrer une définition de couche métallique.

8. Procédé selon l'une quelconque des revendications précédentes, dans lequel ladite étape consistant à définir une interconnexion comprend l'étape consistant à délivrer une définition de trous d'interconnexion.

9. Circuit de détection de circuit ASIC structuré, le circuit comprenant une partie de capteur dudit circuit ASIC structuré et une partie de processeur dudit circuit ASIC structuré, la partie de capteur produisant une sortie brute destinée à être traitée par ladite partie de processeur, la partie de capteur et la partie de processeur comprenant ensemble au moins deux blocs mutuellement configurables par des interconnexions d'une pluralité de manières pour produire des produits de détection différenciés
**caractérisé en ce que** :
ladite partie de capteur comprend une matrice d'éléments photosensibles, et dans lequel ladite matrice de détection est configurable en vue de fournir une configuration de pixels spécifique.

10. Circuit de détection de circuit ASIC structuré selon la revendication 9, dans lequel les interconnexions entre lesdits au moins deux blocs comprennent une interconnexion commune prédéfinie et une interconnexion personnalisée pouvant être spécifiée.

11. Circuit de détection de circuit ASIC structuré selon la revendication 10, dans lequel lesdites interconnexions communes et personnalisées peuvent être spécifiées sur des sous-ensembles distincts des masques de fabrication de circuits ASIC.

12. Circuit de détection de circuit ASIC structuré selon l'une quelconque des revendications 9 à 11, dans lequel lesdites interconnexions sont mises en oeuvre entre la partie de capteur et la partie de processeur.

13. Circuit de détection de circuit ASIC structuré selon l'une quelconque des revendications 9 à 12, dans lequel lesdites interconnexions sont mises en oeuvre au sein de la partie de capteur.

14. Circuit de détection de circuit ASIC structuré selon l'une quelconque des revendications 9 à 13, dans lequel lesdites interconnexions sont mises en oeuvre au sein de la partie de processeur.

15. Circuit de détection de circuit ASIC structuré selon la revendication 11, dans lequel ledit sous-ensemble des masques de fabrication de circuits ASIC pour ladite interconnexion personnalisée comprend des masques supérieurs.
